# EUROPEAN PATENT APPLICATION

(11) **EP 0 537 012 A1**
(43) Date of publication of application: **14.04.1993**
(21) Application number: 92309193.8
(22) Date of filing: 08.10.1992
(51) Int. Cl.: C23C 14/34, H01J 37/34

(54) **Sputtering processes and apparatus**

(30) Priority: 11.10.1991 GB 9121699
(71) Applicant: The BOC Group plc, Windlesham Surrey GU20 6HJ (GB)
(72) Inventor: Thwaites, Michael, Hook, Basingstoke, Hampshire RG27 9PF (GB)
(74) Representative: Bousfield, Roger James

(57) **Abstract**

Apparatus for sputtering thin coatings of material on to a substrate from a chamber subject to substantial evacuation during use, which includes:
- a substantially cylindrical tube (1) having a coating on a surface thereof of the material to be sputtered
- magnetic means (4) associated with the tube for assisting the sputtering process
- means for causing rotation (7) of the tube relative to the magnetic means about its longitudinal axis

wherein the coating is present on the internal surface of the tube (1) and the magnetic means (4) are situated externally of the tube (1).

## Description

This invention relates to processes and apparatus for sputtering thin coatings of material onto a substrate and more particularly to such processes and apparatus utilising a tubular target (cathode) of the coating material.

Cathode sputtering processes are widely used for depositing thin coatings or films of material onto substrates. Such a process takes place in an evacuated chamber containing a small quantity of an ionisable gas, for example argon; electrons emitted from a source held within the chamber ionise the gas to form a plasma and the target comprising the material to be sputtered is bombarded by the ions causing atoms of the target material to be dislodged and subsequently deposited as a film on the substrate being coated.

It is well known that in magnetron apparatus the rate of deposition may be increased by the use of magnetic means, for example an array of permanent magnets positioned in a predetermined manner (commonly as a closed loop), associated with the cathode target to define the area or region, often referred to as the "race-track", from which sputtering, or erosion of the target, occurs.

The target is commonly of flat, elongate and rectangular form and the substrate being coated is moved continuously or intermittently relative to the target during the sputtering process. Apparatus having such a target and having magnetic means of the type described above is known as a planar magnetron.

One disadvantage of the conventional planar magnetron is that the race track along which the sputtering takes place is relatively small and this causes erosion of the target surface in a relatively small, for example ring-shaped, region corresponding to the shape of the closed loop magnetic field. Thus, only a small portion of the total target surface area is consumed before the target needs replacing.

It is also known, however, to replace the planar target with a hollow cylindrical one comprising, or having the outer surface thereof coated with, the material to be sputtered. Apparatus containing such a target is known as a cylindrical magnetron and is sold by Airco Coating Technology (a division of the Applicants) under the trade mark "C-Mag".

In cylindrical magnetron apparatus, the cylindrical target is rotatable about its longitudinal axis either continuously or intermittently during use so that sputtering is not confined to one particular area of the target surface. As with the planar magnetron, the substrate being coated is moved, again either continuously or intermittently, relative to the target in a direction transverse to the longitudinal axis of the target.

The magnetron means in the form of an array of permanent magnets are generally held stationary within the cylindrical target whilst (in use) the latter rotates. However, some adjustment of the magnet array relative to the target is normally possible for overall adjustment prior to each sputtering process. Such apparatus therefore allows a much greater amount of the target to be consumed in the sputtering process by selectively bringing different portions of the target into a sputtering position in respect of the magnetic field formed by the magnets.

However, in the cases of both planar and cylindrical magnetron apparatus, there are difficulties in coating the whole of the external surface of substrates such as tubes, wires and filaments in view in particular of the small surface area of such substrates in comparison with the cathode with the result that most of the sputtered material will miss the substrate and be coated onto other surfaces in the vacuum chamber.

The present invention is concerned with a new sputtering process and apparatus in which a magnetron arrangement allows for the more effective coating of relatively small section substrates such as tubes, rods, wires and the like.

In accordance with the invention, there is provided apparatus for sputtering coatings of material on to a substrate from a chamber subject to substantial evacuation during use, which includes:
- a target tube having on a surface thereof the material to be sputtered
- magnetic means associated with the tube for assisting the sputtering process
- means for causing rotation of the magnetic means relative to the tube about the longitudinal axis of the tube

wherein the material to be sputtered is present on an internal surface of the tube and the magnetic means are situated externally of the tube.

In apparatus of the invention, the tube is preferably substantially cylindrical and the substrate to be coated is positioned within the target tube, preferably centrally on its longitudinal axis, and either kept stationary in batch-type sputtering or, alternatively, continually or continuously fed through the tube at a relevant speed depending on the type and thickness of coating required in a continuous process.

The target tube must have the material to be sputtered on an internal surface. This can be achieved either by the tube being made from the material or by the tube having a layer of the material coated on the internal surface.

The magnetic means must be capable of being rotated about the tube. The nature of the magnetic means may vary. Preferably, however, they comprise an array of elongate permanent magnets whose axes are parallel to the longitudinal axis of the tube. Preferably also the polarity of each magnet is opposite to that of the adjacent magnet(s).

The number of magnets may vary. For example three elongate magnets of alternating polarity may be employed to provide one "racetrack" or, alternatively, numerous magnets of alternating polarity may be present to provide more "racetracks", thereby effecting substantially simultaneous sputtering over much of the surface of the substrate.

Ideally, sufficient magnets are present to provide a continuous circumferential array about the target tube.

In all cases, the magnets must be held in their predetermined position about the tube and provided with means to rotate them about the target tube. In preferred embodiments, the magnets may be attached to the internal surface of a separate tube positioned co-axially about the target tube such that the magnets are held close to the external surface of the target tube during their rotation.

Means are generally required to cool the target tube and this can be achieved, for example, by providing means for the circulation of cooling fluid, for example water, in an area between the target tube and the magnets.

For a better understanding of the invention, reference is now made, by way of exemplification only, to the accompanying drawings, in which:
Figure 1 shows a sectional view through an apparatus of the invention.
Figure 2 shows a sectional view along the line II-II of Figure 1 showing the upper half in more detail.

With reference to the drawings, the apparatus of the invention as shown comprises a target tube 1 which in use forms the cathode. This can either be made from the material to be sputtered or be made from a suitable material to support a coating of the material to be sputtered on its inside surface. A multi-component case 2 whose parts are joined in a vacuum-tight manner is sealed to the tube 1 with further vacuum seals 3.

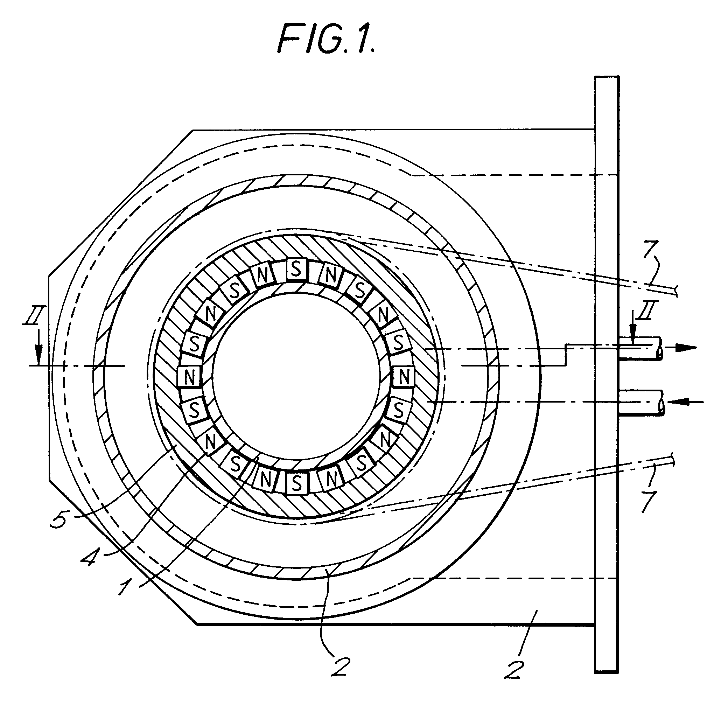

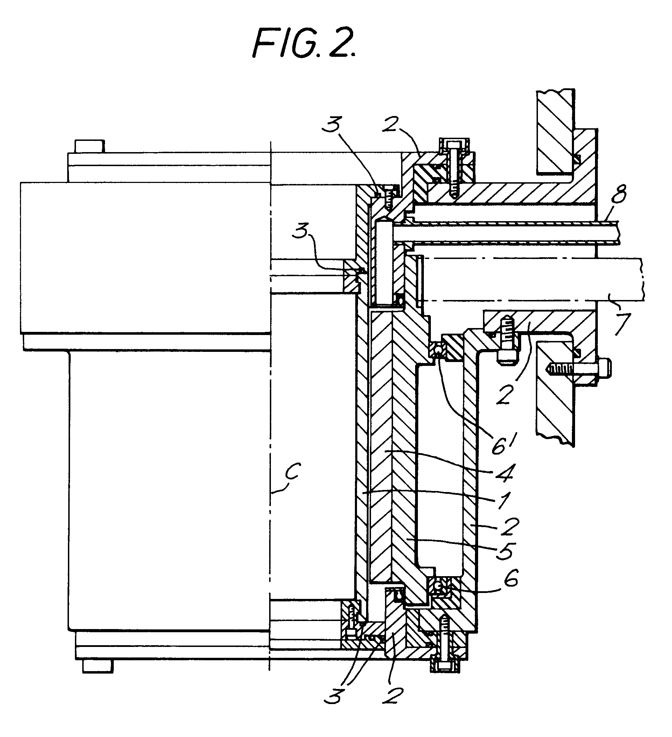

Outside the tube 1 but in close proximity thereto is a system of magnets in the form of a cylindrical array 4. Each individual magnet is elongate (see Figure 2) with its axis parallel to the longitudinal axis of the tube 1 and with a polarity opposite to that of the adjacent magnets (see Figure 1). The individual magnets are mounted on a carrier tube 5 to form the array 4.

The tube 5 is mounted on ball bearings 6 and 6¹ and is arranged for rotation around the tube 1 by means of the belt drive 7. During such rotation in use of the apparatus, the magnets of the array 4 are in close proximity to the external surface of the tube 1.

Means are provided (not shown but indicated at 8 in Figure 2) to circulate water through the space between the tube 1 and the magnet array 4 to keep the tube 1 cool in use during the sputtering process.

Means are also provided to supply the necessary stream of electrons into the chamber formed within the tube 1 and to supply the required quantity of ionisable gas into the chamber, together with means for evacuating the chamber to the required pressure, all in a manner known generally per se.

In use, the space between the tube 5 holding the magnet array 4 and the case 2 is held at atmospheric pressure. A negative voltage is applied to the tube 1 using an insulated copper wire (not shown) running alongside pipes present for the purpose of circulating cooling water. The space inside the tube 1 will be held under high vacuum but, during sputtering, would generally be "back filled" with an ionisable gas such as argon to form the necessary plasma. As such the pressure inside the tube 1 would commonly be in the range 10⁻⁴ to 10⁻¹ Torr.

Wire (or whatever) to be coated by the apparatus of the invention can be fed continuously, continually or intermittently down the centre-line C of the tube 1 from a wire spool and the coated wire can thereafter be collected on a further spool or by any other suitable means.

As stated above, the apparatus of the invention allows small cross-section substrates such as wires, filaments, etc to be coated more effectively than with existing magnetron apparatus in that it allows a large proportion of material from the target tube 1 to be coated onto the substrate. The apparatus has the additional benefit that any sputtered material which does miss the substrate will deposit back into the target tube 1 and be re-sputtered at a later time.

## Claims

1. Apparatus for sputtering coatings of material on to a substrate from a chamber subject to substantial evacuation during use, which includes:
- a target tube having on a surface thereof the material to be sputtered
- magnetic means associated with the tube for assisting the sputtering process
- means for causing rotation of the magnetic means relative to the tube about the longitudinal axis of the tube
wherein the material to be sputtered is present on an internal surface of the tube and the magnetic means are situated externally of the tube.

2. Apparatus according to Claim 1 in which the tube is substantially cylindrical.

3. Apparatus according to Claim 1 or Claim 2 in which the substrate to be coated is positioned centrally within the target tube on its longtitudinal axis.

4. Apparatus according to Claim 3 in which the substrate is kept stationary.

5. Apparatus according to Claim 3 in which the substrate is continually or continuously fed through the tube.

6. Apparatus according to any preceding claim in which the magnetic means comprise an array of elongate permanent magnets whose axes parallel to the longtitudinal axis of the tube.

7. Apparatus according to Claim 6 in which sufficient magnets are preset to provide a continuous circumferential array about the target tube.

8. Apparatus according to Claim 6 or Claim 7 in which the magnets are attached to the internal surface of a separate tube positioned co-axially about the target tube.

9. Apparatus according to any preceding claim in which means are provided to cool the target tube by the circulation of cooling fluid in an area between the target tube and the magnets.
